(19) Europäisches Patentamt
European Patent Office
Office européen des brevets

(11) **EP 1 976 120 A1**

(12) **EUROPEAN PATENT APPLICATION**

(43) Date of publication:
**01.10.2008 Bulletin 2008/40**

(51) Int Cl.:
**H03H 17/06** $^{(2006.01)}$

(21) Application number: **07006795.4**

(22) Date of filing: **31.03.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **SONY DEUTSCHLAND GMBH**
**10785 Berlin (DE)**

(72) Inventor: **Ellermeyer, Björn,**
**c/o SONY Deutschland GmbH**
**70327 Stuttgart (DE)**

(74) Representative: **Müller - Hoffmann & Partner**
**Patentanwälte,**
**Innere Wiener Strasse 17**
**81667 München (DE)**

(54) **Digital filter and method for filtering**

(57) Digital filter, comprising a multiplier configured to generate an intermediate signal, wherein said intermediate signal is generated by multiplying an input signal with a filter coefficient signal, wherein said multiplier is operated at a clock rate and said input signal has a sampling rate, wherein said clock rate is higher than said sampling rate; a first buffer configured to supply said filter coefficient signal to said multiplier at said clock rate, wherein said filter coefficient signal represents N filter coefficients in a periodic order, wherein N denotes the order of said digital filter; a second buffer configured to buffer N/2 samples of an intermediate output signal and to generate a respective time delayed intermediate output signal; and an adder configured to generate said Intermediate output signal or an output signal of said digital filter based on an addition of said time delayed intermediate output signal and said intermediate signal.

Figure

EP 1 976 120 A1

**Description**

BACKGROUND

Today, digital filters are widely used.
It is an object of the invention to provide an efficient digital filter that requires a minimum of components and/or hardware requirements.
This object is solved by a digital filter and method for filtering according to claims 1 and 21, respectively.
Further details of the invention will become apparent from a consideration of the drawings and ensuing description.

BRIEF DESCRIPTION OF THE DRAWINGS

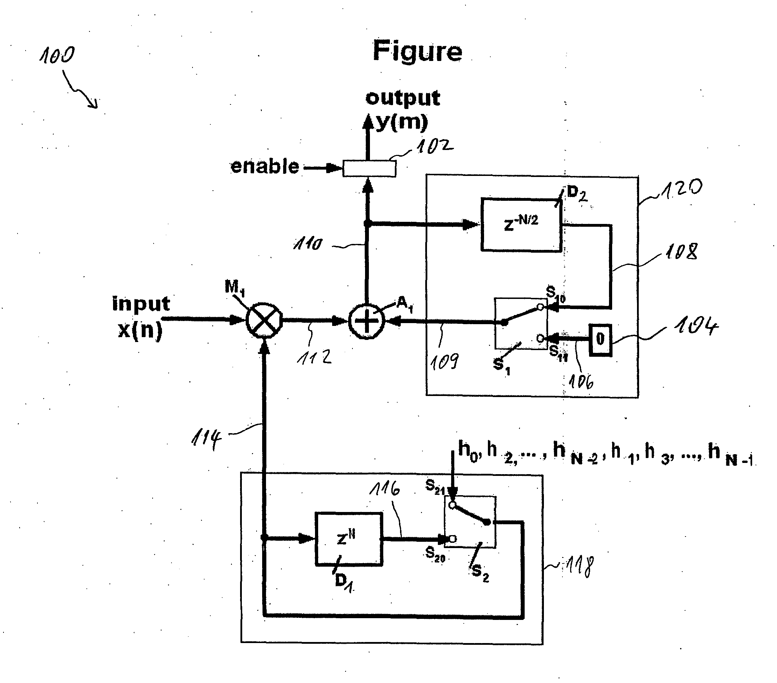

The Figure shows a digital filter according to an embodiment of the invention.

DETAILED DESCRIPTION

In the following, embodiments of the invention are described. It is important to note that all described embodiments in the following may be combined in any way, i.e. there is no limitation that certain described embodiments may not be combined with others.
The Figure shows a digital filter 100 comprising a sample and hold unit 102, multiplier $M_1$, an adder $A_1$, a first switch $S_1$, a zero storage 104, a second buffer $D_2$, a first buffer $D_1$, and a second switch $S_2$.
An input signal $x(n)$ may e.g. be a digital signal comprising samples $x_0$ $x_1$, $x_2$, ...
Input signal $x(n)$ is multiplied with a filter coefficient signal 114 by multiplier $M_1$. The filter coefficient signal 114 comprises the filter coefficients $h_0$, $h_1$, ..., $h_N$ in a predetermined periodical order. In each period of said periodical order, the filter coefficients are arranged in the following order:
$h_0$, $h_2$, ..., $h_{N-2}$, $h_1$, $h_3$, ..., $h_{N-1}$.
Thus, in each or at least one period, first all even filter coefficients $h_0$, $h_2$, ... , $h_{N-2}$ occur, and subsequently, all uneven filter coefficients, $h_1$, $h_3$, ..., $h_{N-1}$.
The filter is operated at a clock rate that is higher than the sampling rate $f_s$ of input signal $x(n)$. In general, the clock rate should be greater than or equal to

$$N \cdot f_s,$$

wherein N denotes the order of the filter and $f_s$ denotes the sampling rate of the input signal $x(n)$.
Multiplier $M_1$ is controlled such that one input sample $x_i$ is multiplied with all even filter coefficients $h_0$, $h_2$, ..., $h_{N-2}$, and that a subsequent input sample $x_{i+1}$ is multiplied with all uneven filter coefficients $h_1$, $h_3$, ..., $h_{N-1}$. In this example, $x_1$ denotes an even input sample, e.g. $x_0$, $x_2$, $x_4$, ..., and $x_{i+1}$ denotes an uneven input sample,

e.g. $x_1$, $x_3$, $x_5$, ...
Thus, intermediate signal 112 generated by multiplier $M_1$ corresponds to products of even filter coefficients $h_0$, $h_2$, ..., $h_{N-2}$ and even input samples $x_0$, $x_2$, $x_4$, ... and products of uneven filter coefficients $h_1$, $h_3$, ... , $h_{N-1}$ and uneven input samples $x_1$, $x_3$, $x_5$ ...
Filter coefficient signal 114 may be determined by any suitable circuit, i.e. it may not be necessary that filter coefficient signal 114 is determined as shown, i.e. based on using the first buffer $D_1$ and second switch $S_2$. Any other suitable circuit or method may be used to provide a filter coefficient signal having the above described properties.
However, in the example of the Figure, filter coefficient signal 114 is determined by loading the above-mentioned order of the filter coefficients into first buffer $D_1$ having a size of N. This may e.g. be done during an initialization phase by switching second switch $S_2$ to position $S_{21}$ for the first N clock signals of the digital filter. After N cycles of the clock rate, second switch $S_2$ will be switched to position $S_{20}$. Thus, after N clock cycles the predetermined order of filter coefficients, $h_0$, $h_2$, ..., $h_{N-2}$, $h_1$, $h_3$, ..., $h_{N-1}$ is loaded into first buffer $D_1$ and a periodical order is realized, wherein during each period the above defined predetermined order of filter coefficients is output via filter coefficient signal 114.
The circuit 118 for generating filter coefficient signal 114 may also be referred to as second ring buffer 118.
Intermediate signal 112 is further processed by adder $A_1$.
Adder $A_1$ adds said intermediate signal 112 and a first switch output signal 109, which is the output signal of first switch $S_1$. First switch output signal 109 is equal to a second buffer output signal 108 if first switch $S_1$ is in position $S_{10}$. Second buffer output signal 108 is the output signal of second buffer $D_2$. If first switch $S_1$ is in position $S_{11}$, then first switch output signal 109 corresponds to a zero signal 106 provided by zero storage 104.
Second buffer $D_2$ has a size of N/2 and, thus, second buffer output signal 108 corresponds to a time delayed version of intermediate output signal 110 of adder $A_1$.
The first switch $S_1$ is always in position $S_{10}$ except for each processing of filter coefficient $h_{N-1}$. In other words, if filter coefficient $h_{N-1}$ is multiplied by multiplier $M_1$ and the resulting intermediate signal 112 is added by adder $A_1$, then at this point in time, first switch output signal 109 will be set to zero by switching first switch $S_1$ to position $S_{11}$.
Second buffer $D_2$ and first switch $S_1$ may be referred to as first ring buffer 120.
Sample and hold unit 102 is controlled to sample and hold intermediate output signal 110, wherein a taking a sample and holding this sample takes place when coefficient $h_1$ has been multiplied with its corresponding input sample and added with its corresponding sample of first switch output signal 109. In other words, each time filter coefficient $h_1$ has been multiplied by multiplier $M_1$ and a corresponding intermediate signal 112 as well as a corresponding intermediate output signal 110 has been generated, the respective sample of intermediate output signal 110 is output as the value for the next output sample of output signal y(m).

Thus, two input samples $x_i$, $x_{i+1}$ result in one output sample, and, therefore, the sampling rate of output signal y(m) is half of the sampling rate of input signal x(n).

First and second buffer $D_1$, $D_2$ may be realized e.g. based on a flip flop, RAM, ROM and/or any other suitable storage.

The following gives a further description of the Figure:

In digital signal processing sampling rate decimation is often needed to reduce the effort of processing a signal. To decimate a signal by a factor of 2 you must delete the signal components, which lies above 1/2 of the sampling rate of the input signal. After this it is allowed by Shannon's law to delete every $2^{nd}$ sample.

In digital receivers often FIR filters are used. When these filters have to be realized on an ASIC it is wishful to make them as small as possible to reduce costs. That means that they should be realized with as few elements as possible.

Here a digital FIR filter realization is shown that consists of only one multiplier. The reduction down to only one multiplier is obtained by running the filter with a higher clock rate and changing the coefficient at the multiplier each clock cycle.

The filter is based on only one multiplier to realize an FIR filter of order N. This can be done as the filter runs with a higher clock rate. The clockrate has to be at least $N*f_s$ (N is the filterorder, $f_s$ is the sampling rate) to ensure enough time to process all coefficients.

To provide the right samples at the right time two ring buffers 118, 120 are used. The $1^{st}$ ring buffer 120 contains the product of the signal samples with the filter coefficients, the $2^{nd}$ ring buffer 118 contains the filter coefficients in the order $h_0$, $h_2$, ... , $h_{N-2}$, $h_1$, $h_2$, ..., $h_{N-1}$. This order is loaded with switch setting $S_{21}$ into the coefficient ring buffer once at start up and then it runs in circle with switch setting $S_{20}$. The size of the filter coefficient ring buffer 118 is N. The order of the $1^{st}$ ring buffer 120 is N/2. In case N is odd the size is ceiled to the next integer. The switch setting of $S_1$ is always $S_{10}$ except for the calculation of filter coefficient $h_{N-1}$.

Thus the $1^{st}$ ring buffer 120 acts as an integrator but has never to be resetted. At startup the content of the $1^{st}$ ring buffer 120 should be initialized to zero. If the first ring buffer 120 is not initialized properly, only the frirst N/2 output samples may be wrong, i.e. all following samples are output correctly even without any initialization.

The Fig. shows a block diagram of the filter structure for this filter.

Each input sample must be valid at the multiplyer $M_1$ to be processed with N/2 filter coeffients. First equal numbered input sample are processed with equal numbered filter coefficients $x_0*h_0$, $x_0*h_2$, ... $x_0*h_{N-2}$. After this odd numbered input sample are processed with odd numbered filter coefficients $x_1*h_1$, $x_1*h_3$, ... $x_1*h_{N-1}$. In case N is odd the size of the odd numbered filter coefficients is one less than the size of the equal numbered filter coefficients.

Two input samples give one output samples. The $i^{th}$ outputsample is valid after the coefficient $h_1$ is multiplied with its corresponding input sample and added with its corresponding value of $1^{st}$ ringbuffer 120. At this time the signal "enable" is valid.

The system is a realization of an decimation by factor 2 with polyphase FIR filter which is reduced in size, e.g. a realization with as few elements as possible. So the realization on an ASIC is smaller and may be cheaper. Only one multiplier is necessary because of running the filter at a higher clock rate, and the memory size of the sample buffer for the filter convolution is halved.

This structure may also be applied in cases of decimation by factor 4, 8, ... $2^x$. In this cases the coefficients have to be reordered and the size of the buffer $D_1$ shrinks by the decimation factor.

For a decimation by factor 4 the order of the coefficients is

$h_0$, $h_4$, ... , $h_{N-4}$, $h_1$, $h_5$, .. , $h_{N-3}$, $h_2$, $h_6$, ..., $h_{N-2}$, $h_3$, $h_7$, ..., $h_{N-1}$.

In this case the size of buffer $D_1$ is equal to N/4.

For a decimation by factor 8 the order of the coefficients is

$h_0$, $h_8$, ... , $h_{N-8}$, $h_1$, $h_9$, ..., $h_{N-7}$, $h_2$, $h_{10}$, ..., $h_{N-6}$, $h_3$, $h_{11}$, ..., $h_{N-5}$,
$h_4$, $h_{12}$, ... , $h_{N-4}$, $h_5$, $h_{13}$, ..., $h_{N-3}$, $h_6$, $h_{14}$, ..., $h_{N-2}$, $h_7$, $h_{15}$...., $h_{N-1}$.

In this case the size of buffer $D_1$ is equal to N/8.

It should be noted that the above explained filter may also be realized by respective method steps. Such a method may then be executed based on a computer program product including computer program instructions that cause a computer to execute the method.

**Claims**

1. Digital filter, comprising:

a multiplier configured to generate an intermediate signal, wherein said intermediate signal is generated by multiplying an input signal with a filter coefficient signal, wherein said multiplier is operated at a clock rate and said input signal has a sampling rate, wherein said clock rate is higher than said sampling rate;
a first buffer configured to supply said filter coefficient signal to said multiplier at said clock rate, wherein said filter coefficient signal represents N filter coefficients in a periodic order, wherein N denotes the order of said digital filter;

a second buffer configured to buffer N/2 samples of an intermediate output signal and to generate a respective time delayed intermediate output signal; and

an adder configured to generate said intermediate output signal or an output signal of said digital filter based on an addition of said time delayed intermediate output signal and said intermediate signal.

2. Digital filter according to claim 1, wherein said multiplier is the only multiplier of said digital filter.

3. Digital filter according to any of the preceding claims, wherein said first buffer and said second buffer are the only buffers of said digital filter.

4. Digital filter according to any of the preceding claims, wherein said first buffer and/or said second buffer are ring buffers.

5. Digital filter according to any of the preceding claims, wherein said first buffer includes a delay element configured to store said N filter coefficients.

6. Digital filter according to claim 5, wherein said first buffer includes a first switch configured to switch between an initialization position and a runtime position, wherein in said initialization position said filter coefficients are loaded into said delay element, and in said runtime position said filter coefficients are read from said delay element and output via said filter coefficient signal.

7. Digital filter according to any of the preceding claims, wherein said second buffer comprises a second switch configured to set said time delayed intermediate output signal to zero if the (N-1)-th filter coefficient is processed.

8. Digital filter according to any of the preceding claims, wherein said digital filter realizes a transposed finite impulse response (FIR) filter.

9. Digital filter according to any of the preceding claims, comprising a sample-and-hold mechanism configured to receive said intermediate output signal and to sample and hold a sample of said intermediate output signal at a point in time when said intermediate output signal corresponds to a valid sample of said output signal of said digital filter.

10. Digital filter according to any of the preceding claims, wherein said periodic order comprises a first and second sequence of said N filter coefficients, wherein said first sequence includes all even filter coefficients and said second sequence includes all uneven filter coefficients.

11. Digital filter according to claim 10, wherein a one sample of said input signal is multiplied with all filter coefficients of said first sequence and a subsequent sample of said input signal is multiplied with all filter coefficients of said second sequence, wherein one output sample of said output signal is output for said one sample and said subsequent sample,

12. Digital filter according to claim 11, wherein in said first sequence all even filter coefficients are arranged in ascending order and in said second sequence all uneven filter coefficients are arranged in ascending order.

13. Digital filter according to any of the preceding claims, wherein said periodic order is based on the following order of filter coefficients: $h_0$, $h_2$, ... , $h_{N-2}$, $h_1$, $h_3$, ..., $h_{N-1}$, wherein $h_1$ denotes the i-th filter coefficient.

14. Digital filter according to any of claims 10 to 13, comprising a sample-and-hold mechanism configured to receive said intermediate output signal and to sample and hold a sample of said intermediate output signal at a point in time when the first uneven filter coefficient ($h_1$) of said second sequence is processed.

15. Digital filter, wherein said clock rate is greater than or equal to N times said sampling rate ($N^*f_s$).

16. Digital filter according to any of the preceding claims, wherein said output signal has an output sampling rate which is essentially equal to one half of the input sampling rate.

17. Digital filter according to any of claims 1 to 9, wherein said output signal has an output sampling rate which is essentially equal to one fourth of the input sampling rate, and wherein said periodic order is based on the following order of filter coefficients: $h_0$, $h_4$, ... , $h_{N-4}$, $h_1$, $h_5$, ..., $h_{N-3}$, $h_2$, $h_6$, ..., $h_{N-2}$, $h_3$, $h_7$, ..., $h_{N-1}$, wherein $h_1$ denotes the i-th filter coefficient.

18. Digital filter according to claim 17, wherein the size of said second buffer is equal to N/4.

19. Digital filter according to any of claims 1 to 9, wherein said output signal has an output sampling rate which is essentially equal to one eighth of the input sampling rate, and wherein said periodic order is based on the following order of filter coefficients: $h_0$, $h_8$, ..., $h_{N-8}$, $h_1$, $h_9$, ..., $h_{N-7}$, $h_2$, $h_{10}$, ..., $h_{N-6}$, $h_3$, $h_{11}$, ..., $h_{N-5}$, $h_4$, $h_{12}$, ..., $h_{N-4}$, $h_5$, $h_{13}$, ..., $h_{N-3}$, $h_6$, $h_{14}$, ..., $h_{N-2}$, $h_7$, $h_{15}$, ..., $h_{N-1}$, wherein $h_i$ denotes the i-th filter coefficient.

20. Digital filter according to claim 19, wherein the size of said second buffer is equal to N/8.

21. Method for filtering an input signal having a sampling rate, comprising:

providing a filter coefficient signal at a clock rate, wherein said filter coefficient signal represents N filter coefficients in a periodic order, wherein N denotes the order of the filtering, and wherein said clock rate is higher than said sampling rate; multiplying, at said clock rate, said input signal with said filter coefficient signal thereby generating an intermediate signal; buffering N/2 samples of an intermediate output signal thereby generating a respective time delayed intermediate output signal; determining said intermediate output signal by adding said time delayed intermediate output signal and said intermediate signal; determining an output signal based on said intermediate output signal.

22. Method according to claim 21, wherein said step of multiplying is the only multiplying step performed for filtering said input signal.

23. Method according to claim 21 or 22, wherein said time delayed intermediate output signal is set to zero if the (N-1)-th filter coefficient is processed.

24. Method according to any of claims 21 to 23, wherein said filtering realizes a transposed finite impulse response (FIR) filtering.

25. Method according to any of claims 21 to 24, wherein said output signal is determined by sampling-and-holding said intermediate output signal at a point in time when said intermediate output signal corresponds to a valid sample.

26. Method according to any of claims 21 to 25, wherein said periodic order comprises a first and second sequence of said N filter coefficients, wherein said first sequence includes all even filter coefficients and said second sequence includes all uneven filter coefficients.

27. Method according to claim 26, wherein in said first sequence all even filter coefficients are arranged in ascending order and in said second sequence all uneven filter coefficients are arranged in ascending order.

28. Method according to claim 26 or 27, wherein said periodic order is based on the following order of filter coefficients: $h_0$, $h_2$, ..., $h_{N-2}$, $h_1$, $h_3$, ..., $h_{N-1}$, wherein $h_1$ denotes the i-th filter coefficient.

29. Method according to any of claims 26 to 28, wherein said output signal is determined by sampling-and-holding said intermediate output signal at a point in time when the first uneven filter coefficient ($h_1$) of said second sequence is processed.

30. Method according to any of claims 21 to 29, wherein said clock rate is greater than or equal to N times said sampling rate ($N*f_s$).

31. Method according to any of claims 21 to 30, wherein said output signal has an output sampling rate which is essentially equal to one half of the input sampling rate.

32. Method according to any of claims 21 to 27, wherein said output signal has an output sampling rate which is essentially equal to one fourth of the input sampling rate, and wherein said periodic order is based on the following order of filter coefficients: $h_0$, $h_4$, ... , $h_{N-4}$, $h_1$, $h_5$, .. , $h_{N-3}$, $h_2$, $h_6$, ..., $h_{N-2}$, $h_3$, $h_7$, ..., $h_{N-1}$, wherein $h_1$ denotes the i-th filter coefficient.

33. Method according to any of claims 21 to 27, wherein said output signal has an output sampling rate which is essentially equal to one eighth of the input sampling rate, and wherein said periodic order is based on the following order of filter coefficients: $h_0$, $h_8$, ..., $h_{N-8}$, $h_1$, $h_9$, ..., $h_{N-7}$, $h_2$, $h_{10}$, .... $h_{N-6}$, $h_3$, $h_{11}$, ..., $h_{N-5}$, $h_4$, $h_{12}$, ... , $h_{N-4}$, $h_5$, $h_{13}$, ..., $h_{N-3}$, $h_6$, $h_{14}$, ..., $h_{N-2}$, $h_7$, $h_{15}$, ..., $h_{N-1}$, wherein $h_1$ denotes the i-th filter coefficient.

34. Digital filter, comprising:

a first buffer configured to generate a first output signal having a clock rate and representing N filter coefficients in a periodic order; a multiplier configured to generate an intermediate signal, wherein said intermediate signal is generated by multiplying an input signal with said first output signal, wherein said input signal has a sampling rate that is lower than said clock rate; a second buffer configured to buffer N/2 samples of an output signal of said digital filter and to generate a respective time delayed output signal; and an adder configured to generate said output signal based on an addition of said time delayed output signal and said intermediate signal.

35. Method for filtering an input signal, comprising:

providing a first output signal having a clock rate and representing N filter coefficients in a periodic order; generating an intermediate signal, wherein said intermediate signal is generated by multiplying an input signal with said first output signal, wherein said input signal has a sampling rate that is lower than said clock rate;

buffering N/2 samples of an output signal, wherein a respective time delayed output signal is generated; and

generating said output signal by adding said time delayed output signal and said intermediate signal.

**36.** A computer program product including computer program instructions that cause a computer to execute a method for filtering an input signal having a sampling rate, comprising:

providing a filter coefficient signal at a clock rate, wherein said filter coefficient signal represents N filter coefficients in a periodic order, wherein N denotes the order of the filtering, and wherein said clock rate is higher than said sampling rate;

multiplying, at said clock rate, said input signal with said filter coefficient signal thereby generating an intermediate signal;

buffering N/2 samples of an intermediate output signal thereby generating a respective time delayed intermediate output signal;

determining said intermediate output signal by adding said time delayed intermediate output signal and said intermediate signal;

determining an output signal based on said intermediate output signal.

Figure

**European Patent Office**

**EUROPEAN SEARCH REPORT**

Application Number

EP 07 00 6795

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 872 290 A (CROOKE ARTHUR W ET AL) 18 March 1975 (1975-03-18) * column 4, line 35 - column 10, line 4; figures 3-5 * | 1-36 | INV. H03H17/06 |
| A | EP 0 285 316 A (TEKTRONIX INC [US]) 5 October 1988 (1988-10-05) * page 4, line 39 - page 6, line 2; figure 2 * * page 7, line 55 - page 8, line 56; figure 3 * | 1-36 | |
| A | US 5 053 983 A (HYATT GILBERT P [US]) 1 October 1991 (1991-10-01) * column 223, line 4 - column 224, line 4; figure 10E * * column 225, line 55 - line 65 * * column 226, line 57 - column 227, line 18 * * column 227, line 23 - line 44 * | 1-36 | |
| A | US 3 930 147 A (BELLANGER MAURICE GEORGES ET AL) 30 December 1975 (1975-12-30) * abstract * * column 3, line 43 - column 7, line 2; figures 1,3 * | 1-36 | TECHNICAL FIELDS SEARCHED (IPC) H03H |
| A | US 4 204 177 A (EGGERMONT LUDWIG D J [NL]) 20 May 1980 (1980-05-20) * abstract * * column 2, line 65 - column 3, line 12; figures 1b,3 * * column 4, line 6 - line 36; figures 8,9 * | 1-36 | |

-/--

The present search report has been drawn up for all claims

| Place of search | Date of completion of the search | Examiner |
|---|---|---|
| Munich | 23 August 2007 | Trafidlo, Renata |

EPO FORM 1503 03.82 (P04C01)

European Patent Office

**EUROPEAN SEARCH REPORT**

Application Number

EP 07 00 6795

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 1 298 799 A1 (SONY INT EUROP GMBH [DE] SONY DEUTSCHLAND GMBH [DE]) 2 April 2003 (2003-04-02) * abstract * * paragraph [0027] - paragraph [0039]; figures 1,2 *  ----- | 1-36 | |
| | | | TECHNICAL FIELDS SEARCHED (IPC) |

The present search report has been drawn up for all claims

| Place of search | Date of completion of the search | Examiner |
|---|---|---|
| Munich | 23 August 2007 | Trafidlo, Renata |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 00 6795

This annex lists the patent family members relating to the patent documents cited in the above-mentioned European search report.
The members are as contained in the European Patent Office EDP file on
The European Patent Office is in no way liable for these particulars which are merely given for the purpose of information.

23-08-2007

| Patent document cited in search report | | Publication date | Patent family member(s) | | Publication date |
|---|---|---|---|---|---|
| US 3872290 | A | 18-03-1975 | NONE | | |
| EP 0285316 | A | 05-10-1988 | JP | 2114906 C | 06-12-1996 |
| | | | JP | 8002014 B | 10-01-1996 |
| | | | JP | 63278411 A | 16-11-1988 |
| | | | US | 4809208 A | 28-02-1989 |
| US 5053983 | A | 01-10-1991 | NONE | | |
| US 3930147 | A | 30-12-1975 | DE | 2422583 A1 | 28-11-1974 |
| | | | FR | 2229336 A5 | 06-12-1974 |
| | | | GB | 1430561 A | 31-03-1976 |
| | | | JP | 1047625 C | 28-05-1981 |
| | | | JP | 50032856 A | 29-03-1975 |
| | | | JP | 55042534 B | 31-10-1980 |
| US 4204177 | A | 20-05-1980 | AU | 8759075 A | 23-06-1977 |
| | | | BE | 836692 A1 | 16-06-1976 |
| | | | CA | 1047125 A1 | 23-01-1979 |
| | | | DE | 2554562 A1 | 24-06-1976 |
| | | | FR | 2295648 A1 | 16-07-1976 |
| | | | GB | 1522169 A | 23-08-1978 |
| | | | JP | 1014386 C | 25-09-1980 |
| | | | JP | 51086341 A | 28-07-1976 |
| | | | JP | 55005291 B | 05-02-1980 |
| | | | NL | 7416479 A | 22-06-1976 |
| | | | SE | 411822 B | 04-02-1980 |
| | | | SE | 7514103 A | 21-06-1976 |
| EP 1298799 | A1 | 02-04-2003 | JP | 2003158445 A | 30-05-2003 |
| | | | US | 2003065693 A1 | 03-04-2003 |

EPO FORM P0459

For more details about this annex : see Official Journal of the European Patent Office, No. 12/82